# EUROPEAN PATENT SPECIFICATION

(11) **EP 3 102 014 B1**
(45) Date of publication and mention of the grant of the patent: **25.11.2020**
(21) Application number: 16172923.1
(22) Date of filing: 03.06.2016
(51) Int. Cl.: H05K 7/20

(54) **ARRANGEMENT FOR COOLING A CABINET**
ANORDNUNG FÜR EINE GEHÄUSEKÜHLUNG
AGENCEMENT DE REFROIDISSEMENT D'UN CABINET

(30) Priority: 04.06.2015 FI 20155426
(43) Date of publication of application: 07.12.2016
(73) Proprietor: MARICI Holdings The Netherlands B.V., 3068AX Rotterdam (NL)
(72) Inventor: TALKA, Ismo, FI-00380 Helsinki (FI); MILLNER, Dan, FI-00380 Helsinki (FI); HAMARI, Juha, FI-00380 Helsnki (FI); TURULA, Ilkka, FI-00380 Helsinki (FI)
(74) Representative: Kolster Oy Ab

(56) References cited:
- WO-A1-99/65284
- WO-A1-2014/155541
- US-A- 5 886 296

## Description

### FIELD

The present invention relates to cooling arrangements for cabinets, especially cabinets for outdoor environment.

### BACKGROUND

There are several devices, like solar or wind power converters, or frequency converters comprising power electronics components dissipating a lot of heat to be transferred out for keeping temperature in a cabinet (1) on an acceptable level. Cabinets for this kind of devices need high enclosure class, like IP67 to protect the control electronics components against dust and moisture. The above mentioned two contrary requirements are challenging to achieve.

WO 9965284 discloses a ventilation device arranged in a wall or door to suction the air from the switch cabinet.

US 5,886,296 discloses a telecommunications equipment enclosure having a hydrophobic vent.

WO 2014155541 A1 discloses a power conversion apparatus and a cooling unit to transfer the heat generated by electric circuit elements.

### SUMMARY

An object of the present invention is to provide an improved arrangement for cooling a cabinet. The object is achieved with an invention, which is defined in the independent claim. Some embodiments are disclosed in the dependent claims.

### DRAWINGS

In the following, the invention will be described in greater detail by means of some embodiments with reference to the accompanying drawings, in which
Figure 1 shows of a cabinet with an embodiment of a cooling arrangement;
Figure 2 shows a cross-sectional view of a cabinet with an embodiment

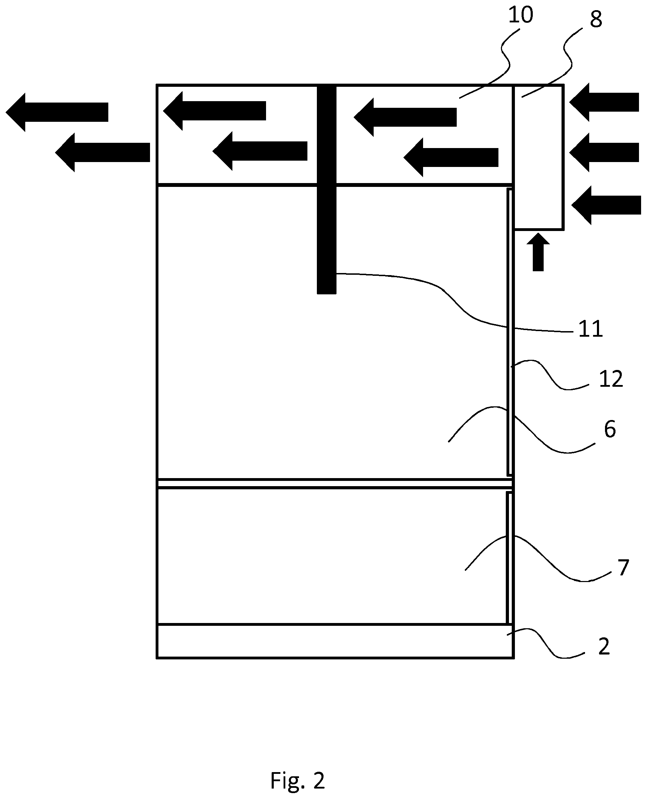

Figure 2 shows a cross-sectional view of a cabinet with an embodiment of a cooling arrangement;

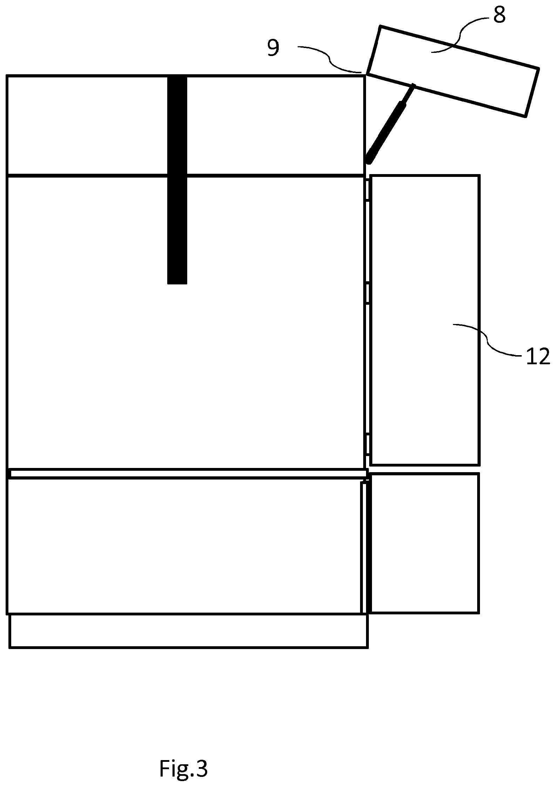

Figure 3 shows a cross-sectional view doors open and filtering device (8) on maintenance position

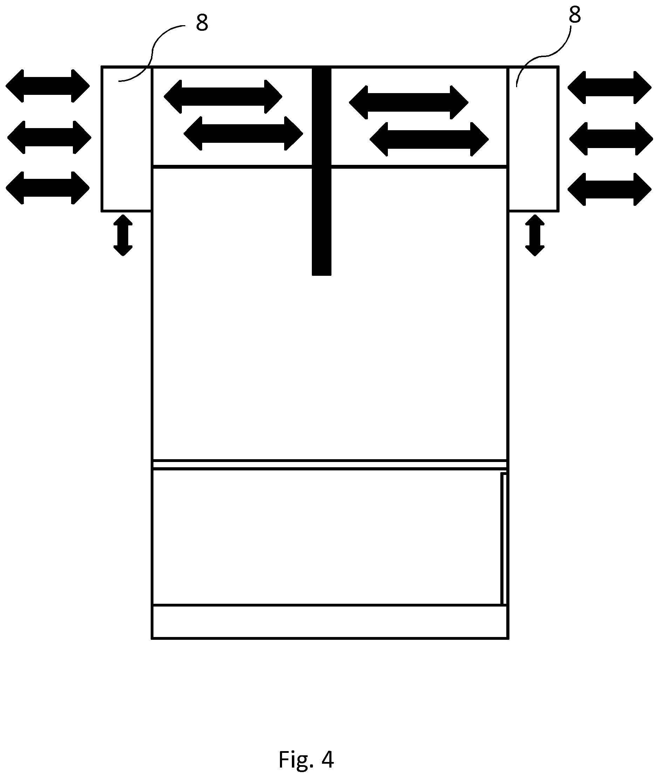

Figure 4 shows an embodiment with a filtering device (8) arranged on each ends of the cooling duct (10);

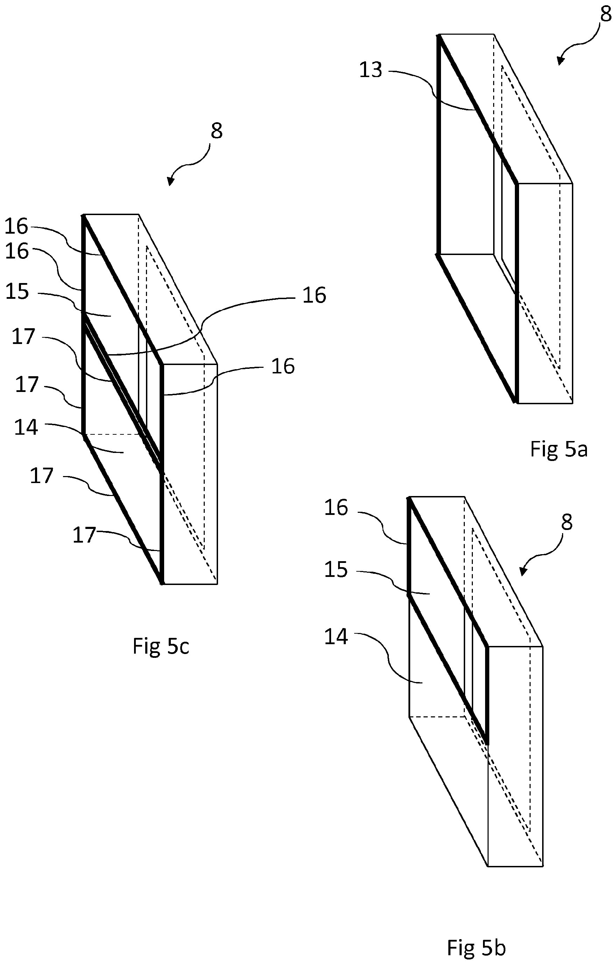

Figure 5a, 5b and 5c show different embodiments of a filtering device.

### DETAILED DESCRIPTION

Several type of devices are assembled in cabinets, preferably made of painted or stainless steel plate. Devices having components dissipating a lot of heat but also temperature sensitive control electronics components, need a cooling arrangement.

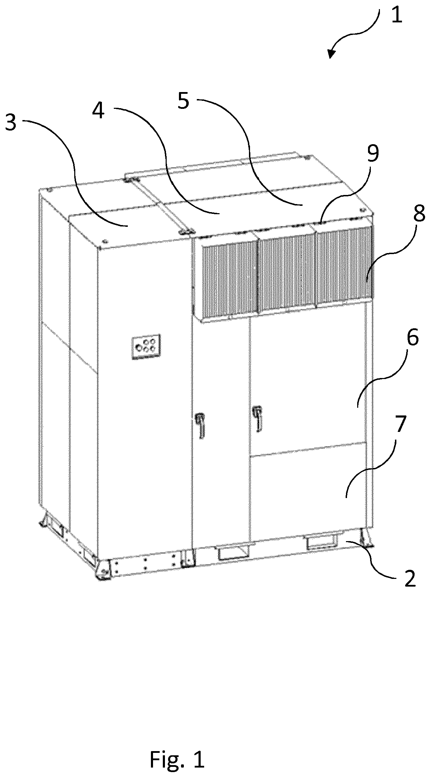

Figure 1 shows an embodiment of a cabinet (1) for an electric apparatus, especially for a solar power plant comprising a basement portion (2) with openings to receive forks of a fork lift truck for transferring the cabinet (1). Further the cabinet (1) comprises several cells for different type of devices. First cell (3) is shared in two departments, an upper department for common control devices and the lower department for AC connection devices, second cell (4) being for accommodating AC components like a circuit breaker for connecting to a power grid and third cell (5) being shared in two departments, the upper department arranged as a chamber (6) for accommodating control and power electronics of a converter and the second, the lower department (7) being for DC connection devices to connect cables coming from solar cells. Being a modular system, several third converter cells (5) may be assembled one adjacent to each other. Each cell may have at least one openable, preferably a hinged door enabling service and maintenance actions.

Further the cabinet (1) comprises one or several air filtering devices (8) for filtering intake air flow. A filtering device (8) comprises a front wall having an aperture covered by a filter element. Preferably the filtering device (8) comprises a grill for protecting the filter element against rain, rodents and vandalism. The filtering device (8) further comprises four side walls i.e. an upper wall, left and right side walls and a lower wall. In some embodiments the lower wall and/or left and/or right side walls may have apertures for further filter elements for enlarging the total filtering area. The width of the side walls defines the depth of the filtering device (8). Depending the desired depth, the filtering area may vary.

The filtering device (8) may be fixed preferably by hinges enabling easy access for maintenance actions, like removing dust from the filter element. An alternative embodiment is fixing the filtering device (8) detachable, like comprising brackets for receiving corresponding pins detached on the roof or wall of the cabinet (1). A hinged filtering device (8) may have a gas spring or a hinged support stick to keep the filtering device (8) on the upper position.

Figure 2 shows a cross-sectional view of the converter cell (5) assembled on the cabinet (1) basement (2). The converter cell (5) is shared on two departments. The upper department being a chamber (6) for accommodating control and power electronics with heat dissipating components. The chamber (6) is separated of the second department (7), the DC connection department without a need for cooling. In an embodiment a cooling duct (10) is located on the top of the converter cell (5), adjacent with the chamber (6) and separated by a wall. A cooling device (11) is arranged to collect heat from the chamber (6) for transferring heat in the cooling duct (10) out from the cabinet (1). A cooling device (11) is preferably a heat exchanger, e.g. a thermosyphon reboiler -type heat exchanger, arranged partly in the chamber (6) and partly in the cooling duct (10).

A filtering device (8) is arranged at the end of the cooling duct (10) for filtering the intake cooling air. The arrows show the principle of air flow through the cooling duct (10). A fan (not shown) is arranged to control the air flow. The fan may be arranged inside the cooling duct (10) or in another embodiment it may be arranged in the filtering device (8).

A cooling duct (10) has a limited space to keep the cabinet (1) size small enough. Reduced cross-sectional area of the cooling duct (10), the speed of the air flow in the cooling duct (10) need correspondingly to be made higher for ensuring an effective cooling process.

An air filter is a resistance for the air flow. Increasing the surface area of the filter decreases the resistance. A cross-sectional area of the filtering device (8) is made larger than a cross-sectional area of the cooling duct (10) for enabling to enlarge the surface area of the filter element. Preferably the cross-sectional area is 20% to 50% larger, most preferably 30% to 40% larger. To avoid the filtering device (8) extending the height of the cabinet (1), the filter device covers part of the chamber (6). In one embodiment the filtering device (8) covers at least part of the door (12) of the chamber (6). The filtering device (8) is fixed turnable by hinges (9) or detachable for enabling to open the door of the chamber (6). The chamber (6) door is sealed with elastic gasket against a cabinet (1) frame and the filtering device (8) is sealed partly against the end of the cooling duct (10) and partly against the cabinet (1) door to avoid air leakage.

Figure 3 shows the filtering device (8) and the door (12) on open positions.

Figure 4 shows an embodiment of a cabinet (1) with a filtering device (8) arranged on the both ends of the cooling duct (10) enabling to change the direction of the air flow in the cooling duct (10) offering a self-cleaning function for filter elements. The cabinet (1) may comprise a temperature sensor in a chamber (6) or pressure and/or vacuum sensors for indicating a need for cleaning the filter element to be done by changing the direction of air flow in the cooling duct (10).

Figures 5a, 5b and 5c show different embodiments of the filtering device (8).

Figure 5a shows an embodiment of the filtering device (8). An elastic sealing (13) is arranged on the outer periphery of the back side of the filtering device (8). The sealing (13) is for sealing the filtering device (8) against the end of the cooling duct (10). The filtering device (8) is arranged to cover part of the chamber (6) door (12) and to be sealed against the outer surface of the chamber (6) door.

Figure 5b shows another embodiment of the filtering device (8). The filtering device (8) comprise a back wall with a back wall surface section (14) and an aperture (15) arranged to be installed against to the end of the cooling duct (10) and sealed by a first sealing section (16) against to the end of the cooling duct (10). The back wall surface section (14) is for preventing airflow. The back wall section (14) is arranged to cover partly the door (12) of the chamber (6) without a need for sealing against the chamber (6) door (12).

Figure 5c shows another embodiment of the filtering device (8). The filtering device (8) comprise a back wall section (14). An aperture (15) is arranged to be installed against to the end of the cooling duct (10) and sealed by the first sealing section (16) against to the end of the cooling duct (10). The filtering device (8) has a second sealing section (17) arranged to be installed against to the frame of the chamber (6). The back wall section is arranged to prevent air flow between the cooling duct (10) and the chamber (6), the filtering device (8) partly covering the doorway and therefore the door (12) of the chamber (6) may be smaller. The back wall section (14) of the filtering device (8) may extend comprising a lip plate (18) faced to the door (12) of the chamber (6). The chamber (6) door (12) is overlapping with the lip plate (18) and a part of the sealing of the door (12) is arranged to cover at least partly the lip plate (18) thus locked door (12) arranged to keep the filtering device (8) locked. The control and power electronics components can preferably be located in a way that for most of the typical maintenance actions only the chamber (6) door needs to be opened. The filtering device (8) may be turned away or lift out in case that components behind the filtering device (8) have to be reached.

It will be obvious to a person skilled in the art that the inventive concept can be implemented in various ways. The invention and its embodiments are not limited to the examples described above but may vary within the scope of the claims.

## Claims

1. Arrangement for cooling a cabinet (1), the cabinet (1) comprising a converter cell (5) with a chamber (6) for accommodating at least one heat dissipating device, a cooling duct (10) located on the top of the converter cell (5), adjacent with the chamber (6) and separated by a wall from the chamber (6) for receiving heat from the chamber (6), a fan for transferring heat in the cooling duct (10) out from the cabinet (1), a filtering device (8) comprising at least one filter element, the filtering device (8) arranged to the end of the cooling duct (10) for filtering intake air, **characterized in that** a cross-sectional area of the filtering device (8) is larger than a cross-sectional area of the cooling duct (10) and **in that** the filtering device (8) is fixed turnable by hinges (9) or detachable for enabling to open the door of the chamber (6).

2. Arrangement for cooling a cabinet (1) according to claim 1, **characterized in that** when the filtering device (8) is fixed turnable by hinges (9), the filtering device (8) is lockable to an open position.

3. Arrangement for cooling a cabinet (1) according to any preceding claims, **characterized in that** the filtering device (8) comprises a back wall section (14) and an aperture (15) arranged to be sealed against the end of the cooling duct (10).

4. Arrangement for cooling a cabinet (1) according to any preceding claims, **characterized in that** the filtering device (8) is arranged to be sealed against the door (12) of the chamber (6).

5. Arrangement for cooling a cabinet (1) according to claim 3, **characterized in that** the filtering device (8) is arranged to cover at least partly a doorway of the chamber (6).

6. Arrangement for cooling a cabinet (1) according to any preceding claim, **characterized in that** a heat exchanger (11) is arranged for transferring heat from the department to the cooling duct (10).

7. Arrangement for cooling a cabinet (1) according to any preceding claim, **characterized in that** a filtering device (8) is arranged to each end of the cooling duct (10) and the fan is arranged for transferring heat forward and backward in the cooling duct (10) for cleaning the filter element by outgoing air.

8. Method for cooling a cabinet (1) comprising a converter cell (5) with a chamber (6) operating a heat dissipating device located in a chamber (6); receiving heat from the chamber (6) by a cooling device (11);
the cooling device being a heat exchanger;
transferring heat in the cooling duct (10) out from the cabinet (1) by a fan;
filtering the intake air by a filtering device (8),
wherein the cabinet (1) is cooled by air flowing into the cooling duct (10) through a filtering device (8) having a cross-sectional area larger than a cross-sectional area of the cooling duct (10) wherein the filtering device (8) is fixed turnable by hinges (9) or detachable for enabling to open the door of the chamber (6).

## Patentansprüche

1. Anordnung zum Kühlen eines Schranks (1), wobei der Schrank (1) eine Wandlerzelle (5) mit einer Kammer (6) zum Aufnehmen von mindestens einer Wärmerabführvorrichtung, einen Kühlkanal (10), der sich auf der Wandlerzelle (5) befindet, der Kammer (6) benachbart und durch eine Wand von der Kammer (6) getrennt ist, zum Empfangen von Wärme aus der Kammer (6), einen Lüfter zum Übertragen von Wärme im Kühlkanal (10) aus dem Schrank (1), eine Filtervorrichtung (8), die mindestens ein Filterelement umfasst, umfasst, wobei die Filtervorrichtung (8) zum Filtern von Ansaugluft zum Ende des Kühlkanals (10) hin angeordnet ist, **dadurch gekennzeichnet, dass** ein Querschnittsbereich der Filtervorrichtung (8) größer ist als ein Querschnittsbereich des Kühlkanals (10), und dadurch, dass die Filtervorrichtung (8) drehbar mittels Scharnieren (9) oder zum Ermöglichen des Öffnens der Tür des Schranks (6) lösbar befestigt ist.

2. Anordnung zum Kühlen eines Schranks (1) nach Anspruch 1, **dadurch gekennzeichnet, dass**, wenn die Filtervorrichtung (8) mittels Scharnieren (9) drehbar befestigt ist, die Filtervorrichtung (8) in einer offenen Position verriegelbar ist.

3. Anordnung zum Kühlen eines Schranks (1) nach einem der vorhergehenden Ansprüche, **dadurch gekennzeichnet, dass** die Filtervorrichtung (8) einen Rückwandabschnitt (14) und eine Öffnung (15), die angeordnet ist, gegen das Ende des Kühlkanals (10) abgedichtet zu werden, umfasst.

4. Anordnung zum Kühlen eines Schranks (1) nach einem der vorhergehenden Ansprüche, **dadurch gekennzeichnet, dass** die Filtervorrichtung (8) angeordnet ist, gegen die Tür (12) der Kammer (6) abgedichtet zu werden.

5. Anordnung zum Kühlen eines Schranks (1) nach Anspruch 3, **dadurch gekennzeichnet, dass** die Filtervorrichtung (8) angeordnet ist, einen Durchgang der Kammer (6) mindestens teilweise abzudecken.

6. Anordnung zum Kühlen eines Schranks (1) nach einem der vorhergehenden Ansprüche, **dadurch gekennzeichnet, dass** zum Übertragen von Wärme von der Abteilung zum Kühlkanal (10) ein Wärmetauscher (11) angeordnet ist.

7. Anordnung zum Kühlen eines Schranks (1) nach einem der vorhergehenden Ansprüche, **dadurch gekennzeichnet, dass** zu jedem Ende des Kühlkanals (10) hin eine Filtervorrichtung (8) angeordnet ist und der Lüfter zum Übertragen von Wärme vor und zurück im Kühlkanal (10) zum Reinigen des Filterelements durch austretende Luft angeordnet ist.

8. Verfahren zum Kühlen eines Schranks (1), der eine Wandlerzelle (5) mit einer Kammer (6), die eine Wärmerabführvorrichtung betreibt, die sich in einer Kammer (6) befindet, umfasst;
Empfangen von Wärme von der Kammer (6) durch eine Kühlvorrichtung (11);
wobei die Kühlvorrichtung ein Wärmetauscher ist; Übertragen von Wärme im Kühlkanal (10) durch einen Lüfter aus dem Schrank (1) heraus;
Filtern der Ansaugluft durch eine Filtervorrichtung (8),
wobei der Schrank (1) durch Luft, die durch eine Filtervorrichtung (8) mit einem Querschnittsbereich, der größer ist als ein Querschnittsbereich des Kühlkanals (10), in den Kühlkanal (10) strömt und wobei die Filtervorrichtung (8) drehbar mittels Scharnieren (9) oder zum Ermöglichen des Öffnens der Tür der Kammer (6) lösbar befestigt ist.

## Revendications

1. Agencement de refroidissement d'une armoire (1), l'armoire (1) comprenant une cellule de convertisseur (5) avec une enceinte (6) pour recevoir au moins un dispositif de dissipation de chaleur, un conduit de refroidissement (10) situé sur le dessus de la cellule de convertisseur (5), adjacent à l'enceinte (6) et séparé de l'enceinte (6) par une paroi pour recevoir la chaleur à partir de l'enceinte (6), un ventilateur pour transférer la chaleur dans le conduit de refroidissement (10) hors de l'armoire (1), un dispositif de filtrage (8) comprenant au moins un élément filtrant, où le dispositif de filtrage (8) est agencé à l'extrémité du conduit de refroidissement (10) pour filtrer l'air d'admission, **caractérisé en ce qu'**une superficie de section transversale du dispositif de filtrage (8) est plus grande qu'une superficie de section transversale du conduit de refroidissement (10) et **en ce que** le dispositif de filtrage (8) est fixé de manière à pouvoir être tourné par des charnières (9) ou détaché pour permettre d'ouvrir la porte de l'enceinte (6).

2. Agencement de refroidissement d'une armoire (1) selon la revendication 1, **caractérisé en ce que**, lorsque le dispositif de filtrage (8) est fixé de manière à pouvoir être tourné par des charnières (9), le dispositif de filtrage (8) peut être verrouillé dans une position ouverte.

3. Agencement de refroidissement d'une armoire (1) selon l'une quelconque des revendications précédentes, **caractérisé en ce que** le dispositif de filtrage (8) comprend une section de paroi arrière (14) et une ouverture (15) agencée de manière à être isolée de l'extérieur contre l'extrémité du conduit de refroidissement (10).

4. Agencement de refroidissement d'une armoire (1) selon l'une quelconque des revendications précédentes, **caractérisé en ce que** le dispositif de filtrage (8) est agencé de manière à être isolé de l'extérieur contre la porte (12) de l'enceinte (6) .

5. Agencement de refroidissement d'une armoire (1) selon la revendication 3, **caractérisé en ce que** le dispositif de filtrage (8) est agencé de manière à couvrir au moins partiellement une embrasure de porte de l'enceinte (6).

6. Agencement de refroidissement d'une armoire (1) selon l'une quelconque des revendications précédentes, **caractérisé en ce qu'**un échangeur de chaleur (11) est agencé pour transférer la chaleur du service vers le conduit de refroidissement (10).

7. Agencement de refroidissement d'une armoire (1) selon l'une quelconque des revendications précédentes, **caractérisé en ce qu'**un dispositif de filtrage (8) est agencé à chaque extrémité du conduit de refroidissement (10) et le ventilateur est agencé pour transférer la chaleur vers l'avant et vers l'arrière dans le conduit de refroidissement (10) pour nettoyer l'élément filtrant par l'air sortant.

8. Procédé de refroidissement d'une armoire (1) comprenant une cellule de convertisseur (5) avec une enceinte (6), qui fait fonctionner un dispositif de dissipation de chaleur situé dans une enceinte (6) ; reçoit de la chaleur à partir de l'enceinte (6) par un dispositif de refroidissement (11) ; où le dispositif de refroidissement est un échangeur de chaleur ; transfère de la chaleur dans le conduit de refroidissement (10) hors de l'armoire (1) par un ventilateur ; filtre de l'air d'admission par un dispositif de filtrage (8),
dans lequel l'armoire (1) est refroidie par l'air s'écoulant dans le conduit de refroidissement (10) à travers un dispositif de filtrage (8) ayant une superficie de section transversale plus grande qu'une superficie de section transversale du conduit de refroidissement (10), et dans lequel le dispositif de filtrage (8) est fixé de manière à pouvoir être tourné par des charnières (9) ou détaché pour permettre d'ouvrir la porte de l'enceinte (6).
